(19) Europäisches Patentamt
European Patent Office
Office européen des brevets

(11) EP 2 990 508 A1

(12) **EUROPEAN PATENT APPLICATION**

(43) Date of publication:
02.03.2016 Bulletin 2016/09

(51) Int Cl.:
*C30B 15/00* (2006.01)　　*C30B 29/06* (2006.01)

(21) Application number: 15182336.6

(22) Date of filing: 25.08.2015

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: 26.08.2014　JP 2014171063

(71) Applicant: **GlobalWafers Japan Co., Ltd.**
**Niigata 957-0197 (JP)**

(72) Inventors:
• **Higasa, Mitsuo**
  **Tokyo, 141-0032 (JP)**
• **Nakagawa, Satoko**
  **Tokyo, 141-0032 (JP)**
• **Nagai, Yuta,**
  **Tokyo, 141-0032 (JP)**
• **Kashima, Kazuhiko**
  **Tokyo, 141-0032 (JP)**

(74) Representative: **Hoffmann Eitle**
**Patent- und Rechtsanwälte PartmbB**
**Arabellastraße 30**
**81925 München (DE)**

(54) **SILICON SINGLE CRYSTAL**

(57)　To provide a silicon single crystal with a longer bulk lifetime and a lower carbon concentration which is fabricated by a Czochralski method and can be suitably applied to IGBT silicon substrates intended for higher withstand voltages. A silicon single crystal is obtained, wherein the crystal lifted up by a Czochralski method has a carbon concentration of $1.0 \times 10^{14}$ atoms/cm$^3$ or less, and a bulk lifetime of 30 msecs or longer, in its crystal body portion having a solidification rate of up to at least 90%, wherein the bulk lifetime is determined by a photo-conductivity decay method.

Fig. 1

SAMPLE A : [Oi]1.0E18　　SAMPLE B : [Oi]1.0E15
SAMPLE C : [Oi]4.0E17　　SAMPLE D : [Oi]1.0E16　　atoms/cm$^3$

BULK LIFETIME [msec]

CARBON CONCENTRATION OF CRYSTAL [atoms/cm$^3$]

## Description

BACKGROUND OF THE INVENTION

Field of the Invention

The present invention relates to silicon single crystals with lower carbon concentrations which were fabricated by Czochralski (hereinafter, abbreviated as CZ) methods suitable for IGBT (Insulated Gate Bipolar Transistor) silicon substrates intended for higher withstand voltages.

Description of the Related Art

Generally, as IGBT silicon substrates intended for higher withstand voltages, which are withstand voltages equal to or higher than 1 kV, there is a need for silicon substrates which have less crystal defects, which form carrier recombination centers, such as oxygen-precipitation cores, and further have longer lifetimes for bulk recombination of carriers (hereinafter, referred to as bulk lifetimes).

Formation of oxygen-precipitation cores in silicon single crystals is mainly caused by carbon impurities, and the growth of oxygen-precipitation cores formed therein is influenced by the oxygen concentrations of the crystals.

As silicon single-crystal ingot fabrication methods, there are CZ methods and FZ (Floating Zone) methods. Silicon single crystals fabricated by FZ methods (hereinafter, abbreviated as FZ silicon single crystals) have significantly-lower oxygen concentrations and, thus, suppress growth of oxygen-precipitation cores therein. Therefore, conventionally, FZ silicon single crystals have been used for IGBT silicon substrates.

On the other hand, in CZ methods, a raw material is charged into a quartz crucible, which causes a significantly-larger amount of oxygen from the quartz crucible to mix therein, thereby making it difficult to lower the oxygen concentration to an equivalent level to those of FZ silicon single crystals. This facilitates growth of oxygen-precipitation cores, which form carrier recombination centers, thereby shortening the bulk lifetimes. Therefore, CZ methods have been unsuitable for IGBT silicon substrates intended for higher withstand voltages.

However, it is technically difficult to make the diameters of FZ silicon single crystals larger, which induces problems in terms of productivity and cost, thereby raising concern about addressing the rapid growth of power device markets in the future.

Therefore, in recent years, in order to use silicon single crystals fabricated by CZ methods which have excellent productivity (hereinafter, abbreviated as CZ silicon single crystals), as IGBT silicon substrates intended for higher withstand voltages, there have been advanced technical developments for improving their quality.

Therefore, the present inventors have developed techniques for growing CZ silicon single crystals with reduced carbon concentrations, in comparison with those of FZ silicon single crystals, and have made studies of the relationship between the carbon concentration and the oxygen concentration of a silicon single crystal, and the bulk lifetime thereof, in focusing attention to carbon impurities which cause formation of oxygen-precipitation cores.

Further, JP 7-89789 A describes the fact that the amount of oxygen-precipitation hardly depends on the carbon concentration, when the carbon concentration is equal to or less than $1.0 \times 10^{14}$ atoms/cm$^3$ (Paragraph 0048).

However, the method for determining the carbon concentration in the aforementioned JP 7-89789 A is an activation analysis using deuterium irradiation, which has a detection limit of $2.5 \times 10^{14}$ atoms/cm$^3$ (refer to Paragraph 0036), which makes it impossible to derive, therewith, the relationship between the carbon concentration, the oxygen concentration and the bulk lifetime, regarding silicon single crystals with carbon concentrations equal to or lower than the detection limit.

Thus, the present inventors have conducted determinations of the carbon concentrations of CZ silicon single crystals with reduced carbon concentrations in comparison with the detection limit of the aforementioned activation analysis by a new evaluation method and made studies as to how such lower carbon concentrations and oxygen concentrations exert influences on the bulk lifetimes. Further, as a result of the aforementioned studies, they have found that it is possible to provide high-quality silicon single crystals with longer bulk lifetimes.

SUMMARY OF THE INVENTION

It is an object of the present invention to provide a CZ silicon single crystal with a longer bulk lifetime and a lower carbon concentration which can be preferably used for IGBT silicon substrates intended for higher withstand voltages.

A silicon single crystal according to the present invention is a silicon single crystal lifted up by a CZ method, wherein the lifted-up crystal has a carbon concentration of $1.0 \times 10^{14}$ atoms/cm$^3$ or less, and a bulk lifetime of 30 msecs or longer, in its crystal body portion having a solidification rate of up to at least 90%, wherein the bulk lifetime is determined by a photoconductivity decay method.

The silicon single crystal with such a lower carbon concentration exhibits a bulk lifetime equal to or longer than those of FZ silicon single crystals, regardless of the oxygen concentration.

Preferably, the aforementioned carbon concentration of the silicon single crystal is determined by a Photo Luminescence (PL) method.

With such a PL method, it is possible to accurately determine even lower carbon concentrations, which are carbon concentrations equal to or lower than

$1.0 \times 10^{14}$ atoms/cm$^3$.

According to the present invention, it is possible to provide a silicon single crystal having a bulk lifetime equal to or longer than those of FZ silicon single crystals, regardless of the oxygen concentration, provided that its carbon concentration is equal to or less than $1.0 \times 10^{14}$ atoms/cm$^3$, even though the silicon single crystal is a CZ silicon single crystal. Such a silicon single crystal can be preferably applied to IGBT silicon substrates intended for higher withstand voltages and, further, has the advantage that it can be obtained with a lower cost and higher efficiency in comparison with FZ silicon single crystals.

BRIEF DESCRIPTION OF THE DRAWING

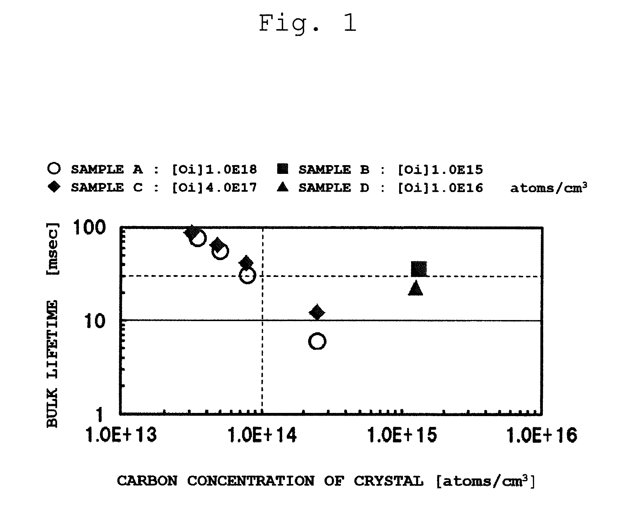

FIG. 1 is a graph illustrating the relationship between the carbon concentrations of respective silicon single crystal samples, and the bulk lifetimes thereof, according to examples.

DETAILED DESCRIPTION OF THE EMBODIMENTS

Hereinafter, the present invention will be described in more detail.

A silicon single crystal according to the present invention is a silicon single crystal lifted up by a CZ method. Further, the lifted-up crystal has a carbon concentration of $1.0 \times 10^{14}$ atoms/cm$^3$ or less, and a bulk lifetime of 30 msecs or more, in its crystal body portion having a solidification rate of up to at least 90%, wherein the bulk lifetime is determined by a photoconductivity decay method.

When the silicon single crystal has a significantly-lower carbon concentration as described above, the silicon single crystal can be made to have an increased bulk lifetime, regardless of the oxygen concentration, and, thus, can be made to have a bulk lifetime equal to or longer than those of FZ silicon single crystals having lower oxygen concentrations than those of CZ silicon single crystals.

Further, as the carbon concentration of the aforementioned CZ silicon single crystal is decreased, the influence of the oxygen concentration on the decrease of the bulk lifetime can be reduced. This is assumed to be because carbon contributes to heterogeneous nucleation of oxygen precipitates, and oxygen precipitates (cores), which form recombination centers, can be decreased as the carbon concentration is lowered.

The bulk lifetime as described above is a value determined in the crystal body portion having a lifted-up crystal solidification rate of up to at least 90%, out of the aforementioned silicon single crystal.

In order to obtain high-quality wafers from the aforementioned silicon single crystal with an excellent yield, it is preferable to provide a higher bulk lifetime value within the aforementioned range in the lifted-up crystal body portion.

The aforementioned silicon single crystal has a carbon concentration of $1.0 \times 10^{14}$ atoms/cm$^3$ or less.

If the aforementioned carbon concentration exceeds $1.0 \times 10^{14}$ atoms/cm$^3$, it is difficult to improve the bulk lifetime to an equivalent level to those of FZ silicon single crystals.

Preferably, such a significantly-lower carbon concentration is determined by a PL method.

Among methods for analyzing carbon concentrations of silicon single crystals, FT-IR (Fourier Transform Infrared Spectroscopy) methods are a main stream. However, FT-IR methods have a carbon detection lower limit of about $2.0 \times 10^{15}$ atoms/cm$^3$, which makes it difficult to accurately evaluate, therewith, the carbon concentration of the silicon single crystal according to the present invention.

Further, as a method capable of evaluating lower carbon concentrations than those by FT-IR methods, there have been known charged particle activation analysis methods. However, these methods have a lower detection limit of about $2.0 \times 10^{14}$ atoms/cm$^3$ and, therefore, these methods are also unsuitable as methods for evaluating the lower carbon concentration of the silicon single crystal according to the present invention.

In the present invention, in order to provide a silicon single crystal with a lower carbon concentration, it is necessary to accurately determine carbon concentrations equal to or lower than $1.0 \times 10^{14}$ atoms/cm$^3$.

Therefore, the carbon concentration of the silicon single crystal is preferably determined by means of a PL method as follows. From the silicon single crystal, the carbon concentration of which is to be determined, silicon wafer samples are sliced. The samples are irradiated with 1 MeV electrons with a fluence of $7 \times 10^{16}$ electrons/cm$^2$ at room temperature. For instance, high-energy electrons from the Cockcroft-Walton-type accelerator of the Japan Atomic Energy Agency can be used. The PL measurements are performed on mirror-polished surfaces of the samples immersed in liquid helium. The luminescence excited by the 532 nm line of Nd: YVO$_4$ laser is analyzed using a monochromator with a 300-groove/mm grating blazed at 1000 nm. Luminescence is detected using a cooled InGaAs photodiode array to result in PL spectra. In the thus-obtained PL spectra, the ratio between the intensity of the G-line (appearing at 0.97 eV) and the free exciton (FE) lines (G/FE ratio) is determined. From the G/FE ratio, the carbon concentration $[C_S]$ is calculated using the following equation:

$$G/FE = 2 \times 10^{-22} \times [C_s]^{1.5}.$$

By means of the above method, extremely-low carbon concentrations of silicon single crystals, which are carbon concentrations of about $1.0 \times 10^{13}$ atoms/cm$^3$,

can be determined. For more details of the method, reference can be made to S. Nakagawa, K. Kashima, M. Tajima, Proceedings of the Forum on the Science and Technology of Silicon Materials 2010 (2010) 326. That is a preferred method of measuring the carbon concentration of the silicon single crystal according to the present invention by means of a PL method is described in the above paper by S.Nakagawa et al.

Further, the silicon single crystal according to the present invention has a bulk lifetime value of 30 msecs or more, wherein the bulk lifetime value is determined by a photoconductivity decay method.

The method for determining the bulk lifetime by the photoconductivity decay method is a method standardized by JIS H 0604 and ASTM F28, wherein the determination is performed in a contact manner, using determination samples with a rectangular-column shape. This method has the advantage of being less influenced by surface recombination velocities and, thus, being capable of determining longer lifetimes without necessitating passivation, in comparison with $\mu$PCD methods adapted to perform determinations on wafers by laser pulse irradiation in a non-contact manner.

If the bulk lifetime value determined by this method is equal to or more than 30 msecs, the silicon single crystal has a bulk lifetime equal to or longer than those of FZ silicon single crystals and, therefore, can be suitably applied to IGBT silicon substrates intended for higher withstand voltages.

Further, while the silicon single crystal according to the present invention is lifted up by a CZ method, it is preferable to lift up the silicon single crystal by a so-called MCZ method adapted to apply a lateral magnetic field to a raw-material molten liquid, in view of suppressing convection of the aforementioned raw-material molten liquid during lifting up, suppressing elution of oxygen into the raw-material molten liquid from the quartz crucible, and reducing the oxygen concentration of the silicon single crystal.

More specifically, it is possible to lift up a silicon single crystal according to the present invention as described above, by controlling various conditions such as the crucible rotational speed, the flow velocity of an inert gas, the heater power (refer to JP 2013-146005 A of the present applicant).

Examples

Hereinafter, the present invention will be described in more detail with reference to examples, but the present invention is not intended to be restricted by the following examples.

(Fabrication of Samples)

The following Samples A to D were fabricated.
Further, each of the following samples was determined in oxygen concentration by an FT-IR method and, further, was determined in carbon concentration by a PL method.

[Samples A and B]

Silicon single crystals with an oxygen concentration (old ASTM) of $1.0\times10^{18}$ atoms/cm$^3$ were prepared as Sample A, and silicon single crystals with an oxygen concentration of $4.0\times10^{17}$ atoms/cm$^3$ were prepared as Sample B, wherein these silicon single crystals were non-doped p-type silicon single crystals (with a resistance range of 7 to 20 k$\Omega$cm) lifted up by a CZ method.
As the respective silicon single crystals as Samples A and B, samples with various carbon concentrations ($7.0\times10^{12}$ to $2.0\times10^{15}$ atoms/cm$^3$) were fabricated.

[Sample C]

A silicon single crystal with an oxygen concentration (old ASTM) of $1.0\times10^{15}$ atoms/cm$^3$ was prepared as Sample C, wherein this silicon single crystal was a non-doped p-type silicon single crystal (with a resistance range of 7 to 20 k$\Omega$cm) fabricated by an FZ method using a CVD raw-material silicon.

[Sample D]

A silicon single crystal with an oxygen concentration (old ASTM) of $1.0\times10^{16}$ atoms/cm$^3$ was prepared as Sample D, wherein this silicon single crystal was a non-doped p-type silicon single crystal (with a resistance range of 7 to 20 k$\Omega$cm) fabricated by an FZ method using a CZ raw-material silicon.

(Determination of Bulk Lifetime)

The aforementioned respective samples were worked into a rectangular column shape with a size of 20 mm $\times$ 20 mm x80 mm to be bulk-life-time determination samples, and electrode contact portions therein were coated with Ga.
The determinations of their bulk lifetimes were conducted using a lifetime tester (HF-100DCA manufactured by Napson Corporation).
FIG. 1 illustrates a graph of the relationship between the carbon concentration of each silicon single-crystal sample, and the bulk lifetime thereof, which was resulted from the aforementioned determination.
As can be seen from the result illustrated in FIG. 1, regarding the CZ silicon single crystals (Samples A and B), when the carbon concentration was equal to or less than $1.0\times10^{14}$ atoms/cm$^3$ and, therefore, was a lower concentration, the bulk lifetime was increased with decreasing carbon concentration, regardless of the oxygen concentration, and when the carbon concentration was equal to or less than $1.3\times10^{13}$ atoms/cm$^3$, the bulk lifetime was increased to about 100 msecs.

On the other hand, regarding the FZ silicon single crystals (Samples C and D) having lower oxygen concentrations, which were oxygen concentrations equal to or less than 1/10 of those of the CZ silicon single crystals, they had a carbon concentration of $1.2 \times 10^{15}$ atoms/cm$^3$ and a bulk lifetime of 30 msecs.

Accordingly, it was recognized that even CZ silicon single crystals having higher oxygen concentrations can have bulk lifetimes equal to or longer than those of FZ silicon single crystals, provided that they have carbon concentrations of $1.0 \times 10^{14}$ atoms/cm$^3$ or less.

Further, it can be said that the influence of the oxygen concentration on the bulk lifetime decreases with decreasing carbon concentration.

**Claims**

1. A silicon single crystal lifted up by a Czochralski method,
   wherein the lifted-up crystal has a carbon concentration of $1.0 \times 10^{14}$ atoms/cm$^3$ or less, and a bulk lifetime of 30 msecs or longer, in its crystal body portion having a solidification rate of up to at least 90%, the bulk lifetime being determined by a photoconductivity decay method.

2. The silicon single crystal according to Claim 1, wherein the carbon concentration is determined by a Photo Luminescence method.

# Fig. 1

○ SAMPLE A : [Oi]1.0E18    ■ SAMPLE B : [Oi]1.0E15
◆ SAMPLE C : [Oi]4.0E17    ▲ SAMPLE D : [Oi]1.0E16    atoms/cm³

Europäisches
Patentamt

European
Patent Office

Office européen
des brevets

# EUROPEAN SEARCH REPORT

Application Number

EP 15 18 2336

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,P | EP 2 824 222 A1 (GLOBALWAFERS JAPAN CO LTD [JP]) 14 January 2015 (2015-01-14)<br>* claims 1, 3 *<br>* examples 1, 2 *<br>----- | 1,2 | INV.<br>C30B15/00<br>C30B29/06 |
| X | JP 2012 201564 A (COVALENT MATERIALS CORP) 22 October 2012 (2012-10-22)<br>* figures 1, 8 *<br>----- | 1,2 | |
| X | Yuta Nagai ET AL: "science24.com - Crystal growth of MCZ silicon with ultra low carbon concentration",<br>17th International Conference on Crystal Growth and Epitaxy - ICCGE-17,<br>14 August 2003 (2003-08-14), pages 1-3, XP055152011,<br>17th International Conference on Crystal Growth and Epitaxy - ICCGE-17, 2013 Warsaw, Poland<br>Retrieved from the Internet:<br>URL:http://science24.com/paper/29506 [retrieved on 2014-11-10]<br>* the whole document *<br>----- | 1,2 | |
| X | NAGAI Y ET AL: "Crystal growth of MCZ silicon with ultralow carbon concentration",<br>JOURNAL OF CRYSTAL GROWTH, ELSEVIER, AMSTERDAM, NL,<br>vol. 401, 28 November 2013 (2013-11-28), pages 737-739, XP029040642,<br>ISSN: 0022-0248, DOI:<br>10.1016/J.JCRYSGRO.2013.11.059<br>* abstract *<br>* figures 1-3 *<br>----- | 1,2 | |

TECHNICAL FIELDS
SEARCHED (IPC)

C30B

The present search report has been drawn up for all claims

| Place of search | Date of completion of the search | Examiner |
|---|---|---|
| The Hague | 20 November 2015 | Schmitt, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 15 18 2336

This annex lists the patent family members relating to the patent documents cited in the above-mentioned European search report.
The members are as contained in the European Patent Office EDP file on
The European Patent Office is in no way liable for these particulars which are merely given for the purpose of information.

20-11-2015

| Patent document cited in search report | | | Publication date | Patent family member(s) | | | Publication date |
|---|---|---|---|---|---|---|---|
| EP 2824222 | A1 | | 14-01-2015 | CN | 104278321 | A | 14-01-2015 |
| | | | | EP | 2824222 | A1 | 14-01-2015 |
| | | | | JP | 2015017019 | A | 29-01-2015 |
| | | | | KR | 20150007962 | A | 21-01-2015 |
| | | | | TW | 201504486 | A | 01-02-2015 |
| | | | | US | 2015017086 | A1 | 15-01-2015 |
| JP 2012201564 | A | | 22-10-2012 | JP | 5561785 | B2 | 30-07-2014 |
| | | | | JP | 2012201564 | A | 22-10-2012 |

For more details about this annex : see Official Journal of the European Patent Office, No. 12/82

## REFERENCES CITED IN THE DESCRIPTION

**Patent documents cited in the description**

- JP 7089789 A

- JP 2013146005 A

**Non-patent literature cited in the description**

- **S. NAKAGAWA ; K. KASHIMA ; M. TAJIMA.** *Proceedings of the Forum on the Science and Technology of Silicon Materials,* 2010, 326